# EUROPEAN PATENT APPLICATION

(11) **EP 4 811 989 A1**
(43) Date of publication of application: **23.09.2026**
(21) Application number: 23958944.3
(22) Date of filing: 14.11.2023
(51) Int. Cl.: H10K 59/80, G09F 9/30, G06F 1/16, H04N 5/65, H05K 5/03, G02F 1/1333, F16H 7/02, H10K 102/00

(54) **DISPLAY DEVICE**

(71) Applicant: LG Electronics Inc., Yeongdeungpo-gu Seoul 07336 (KR)
(72) Inventor: PYO, Jonggil, Seoul 06772 (KR)
(74) Representative: Vossius & Partner Patentanwälte Rechtsanwälte mbB
(86) International application number: PCT/KR2023/018246
(87) International publication number: WO 2025/105517

(57) **Abstract**

A display device is disclosed. The display device may comprise: a display panel that displays an image and has transparency; a transparent panel facing the display panel; a side frame elongated along the lateral side of the display panel and coupled to the transparent panel; a belt that is embedded in the side frame and moves along the longitudinal direction of the side frame; a bar which is elongated in a direction intersecting the side frame, and of which one end is fixed to the belt; a roller, which is adjacent to the lower side of the display panel connected to the lateral side thereof, is elongated along the lower side of the display panel, and is rotatable; a light-shielding film of which one end is fixed to the bar, and of which the other end is coupled to the roller so as to be wound around or unwound from the roller when the bar moves; an upper pulley which is positioned above the side frame and which has the belt wound therearound; and a driving pulley, which is adjacent to the bottom of the side frame, faces the light-shielding film, rotates around an axis in the thickness direction of the light-shielding film, and has the belt wound therearound, wherein the bar includes a first piece forming a portion of the bar, and a second piece, which is coupled to the first piece and has the light-shielding film wound therearound, and the second piece includes a lower piece fixed to the first piece, and an upper piece that moves on the lower piece in the direction from the driving pulley toward the upper pulley.

## Description

### [Technical Field]

The present disclosure relates to a display device. More particularly, the present disclosure relates to a display device including a transparent display panel.

### [Background Art]

With the development of information society, there has been a growing demand for various types of display devices. In order to meet such demand, various display devices, such as a liquid crystal display (LCD) device, a plasma display panel (PDP), an electro luminescent display (ELD), a vacuum fluorescent display (VFD), an organic light emitting diode (OLED) display, and the like, have been developed and used.

Among them, an LCD panel includes a TFT substrate and a color substrate that are positioned opposite each other with a liquid crystal layer interposed therebetween, and can display an image using light provided from a backlight unit. In addition, an OLED panel can display an image by depositing a self-luminescent organic layer on a substrate having a transparent electrode formed thereon.

Recently, much research has been conducted on a transparent display panel that not only displays an image to a user but also allows the user to view an object behind the display panel.

### [Technical Problem]

It is an object of the present disclosure to solve the above and other problems.

It is another object of the present disclosure to provide a display device including a transparent display panel.

It is another object of the present disclosure to provide a structure and a driving mechanism for opening and closing the rear side or surface of a transparent display panel.

It is another object of the present disclosure to provide a frame structure in which a transparent display panel and a light-shielding film are coupled.

It is another object of the present disclosure to provide a driving mechanism for a film for shielding a transparent display panel from light.

It is another object of the present disclosure to provide a coupling structure of a light-shielding film for providing tension to the light-shielding film.

### [Technical Solution]

In accordance with an aspect of the present disclosure, the above and other objects can be accomplished by providing a display device including: a display panel configured to display an image and having light transmittance; a transparent panel facing the display panel; a side frame elongated along a lateral side of the display panel and coupled to the transparent panel; a belt embedded in the side frame and configured to move along a longitudinal direction of the side frame; a bar extending in a direction intersecting the side frame, the bar having one end fixed to the belt; a roller adjacent to a lower side connected to the lateral side of the display panel, elongated along the lower side of the display panel, and configured to be rotatable; a light-shielding film having one end fixed to the bar and another end coupled to the roller, such that the light-shielding film is wound around or unwound from the roller when the bar moves; an upper pulley disposed at an upper side of the side frame and around which the belt is wound; and a driving pulley disposed adjacent to a lower side of the side frame, facing the light-shielding film, configured to rotate about an axis extending in a thickness direction of the light-shielding film, and around which the belt is wound, wherein the bar includes: a first piece forming a portion of the bar; and a second piece coupled to the first piece and around which the light-shielding film is wound, and wherein the second piece includes: a lower piece fixed to the first piece; and an upper piece configured to move on the lower piece in a direction from the driving pulley toward the upper pulley.

### [Advantageous Effects]

A display device according to the present disclosure has the following effects.

According to at least one of the embodiments of the present disclosure, it is possible to provide a display device including a transparent display panel.

According to at least one of the embodiments of the present disclosure, it is possible to provide a structure and a driving mechanism for opening and closing the rear side or surface of a transparent display panel.

According to at least one of the embodiments of the present disclosure, it is possible to provide a frame structure in which a transparent display panel and a light-shielding film are coupled.

According to at least one of the embodiments of the present disclosure, it is possible to provide a driving mechanism for a film for shielding a transparent display panel from light.

According to at least one of the embodiments of the present disclosure, it is possible to provide a coupling structure of a light-shielding film for providing tension to the light-shielding film.

Further scope of applicability of the present disclosure will become apparent from the following detailed description. However, it should be understood that the detailed description and specific embodiments such as preferred embodiments of the present disclosure are given by way of example only, since various changes and modifications within the idea and scope of the present disclosure may be clearly understood by those skilled in the art.

### [Brief Description of Drawings]

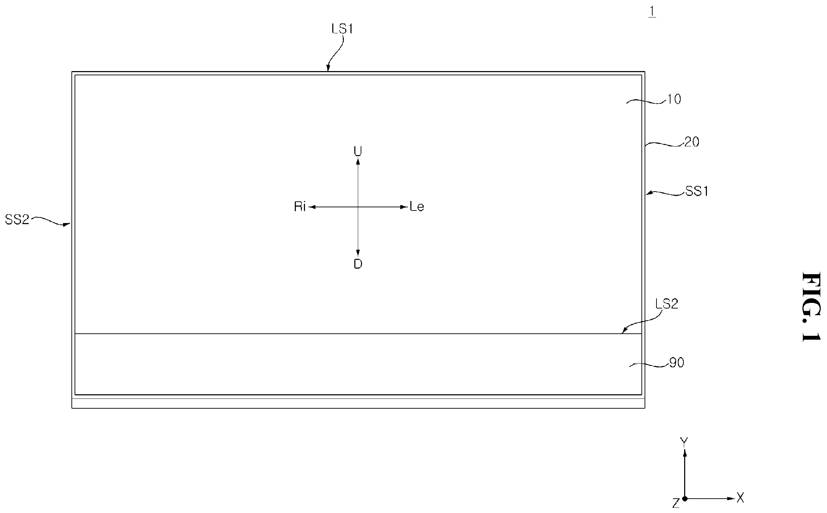

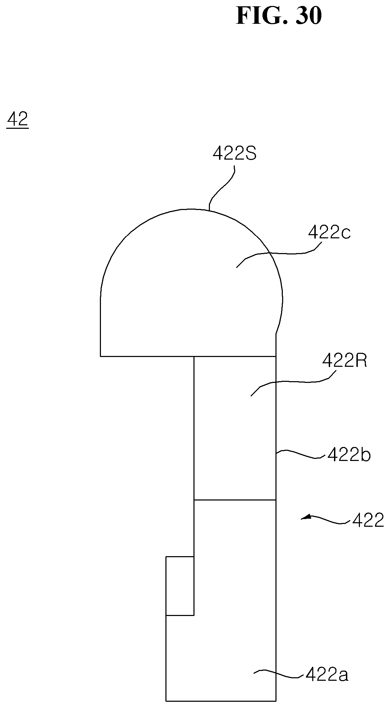

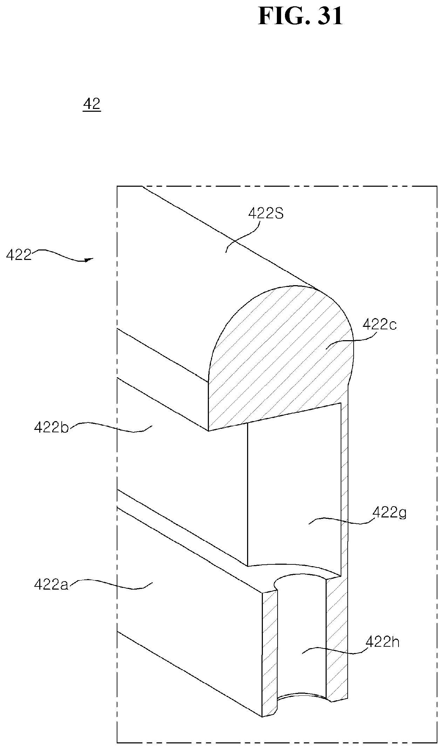

FIGS. 1 to 37 are diagrams illustrating examples of a display device according to embodiments of the present disclosure.

### [Mode for the Invention]

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In the following description, a suffix such as "module" and "unit" may be used to refer to elements or components. Use of such a suffix herein is merely intended to facilitate description of the specification, and the suffix itself is not intended to give any special meaning or function.

In the present disclosure, that which is well known to one of ordinary skill in the relevant art has generally been omitted for the sake of brevity. The accompanying drawings are used to help easily understand various technical features and it should be understood that the embodiments disclosed herein are not limited by the accompanying drawings. As such, the present disclosure should be construed to extend to any alterations, equivalents, and substitutes in addition to those which are particularly set out in the accompanying drawings.

Although the terms "first", "second", etc. may be used herein to describe various elements, these elements should not be limited by these terms. These terms are only used to distinguish one element from another.

It will be understood that when an element is referred to as being "coupled" or "connected" to another element, it may be directly coupled or connected to another element, or intervening elements may be present. In contrast, when an element is referred to as being "directly coupled" or "directly connected" to another element, there are no intervening elements present.

A singular representation may include a plural representation unless the context clearly indicates otherwise.

It will be further understood that the terms "comprise", "include", "have", etc. when used in this specification, specify the presence of stated features, numbers, steps, operations, elements, components, or combinations thereof, but do not preclude the presence or addition of one or more other features, numbers, steps, operations, elements, components, or combinations thereof.

The directions "up (U)", "down (D)", "left (Le)", "right (Ri)", "front (F)", and "rear (R)" shown in the drawings are provided for convenience of description only, and are not intended to limit the technical scope of the present disclosure.

Referring to FIG. 1, a display device 1 may include a display 10, a side frame 20, and a housing 90. The display 10 may display an image. The side frame 20 may extend along a periphery of the display 10. The housing 90 may be positioned at a lower side of the display 10 and the side frame 20. Alternatively, the housing 90 may be positioned at an upper, left, or lower side of the display 10 and the side frame 10.

The display 10 may include a first long side LS1, a second long side LS2 opposite the first long side LS1, a first short side SS1 adjacent to the first long side LS1 and the second long side LS2, and a second short side SS2 opposite the first short side SS1.

For convenience of explanation, it is illustrated and described that lengths of the first and second long sides LS1 and LS2 are greater than lengths of the first and second short sides SS1 and SS2, but the lengths of the first and second long sides LS1 and LS2 may be substantially equal to the lengths of the first and second short sides SS1 and SS2.

A direction parallel to the long sides LS1 and LS2 of the display 10 may be referred to as a left-right direction. A direction parallel to the short sides SS1 and SS2 of the display 10 may be referred to as an up-down direction. A direction perpendicular to the long sides LS1 and LS2 and the short sides SS1 and SS2 of the display 10 may be referred to as a front-rear direction.

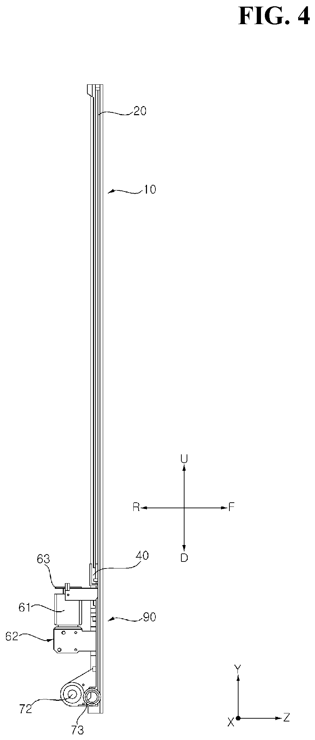

A direction in which the display 10 displays an image may be referred to as a front (F, z) (see FIG. 4), and a direction opposite thereto may be referred to as a rear (R, -z) (see FIG. 4). The first short side SS1 may be referred to as a left side (Le, x), and the second short side SS2 may be referred to as a right side (Ri, -x). The first long side LS1 may be referred to as an upper side (U, y), and the second long side LS2 may be referred to as a lower side (D, -y).

Hereinafter, a display panel using an organic light emitting diode (OLED) will be described as an example, but the display panel applicable to the present disclosure is not limited thereto.

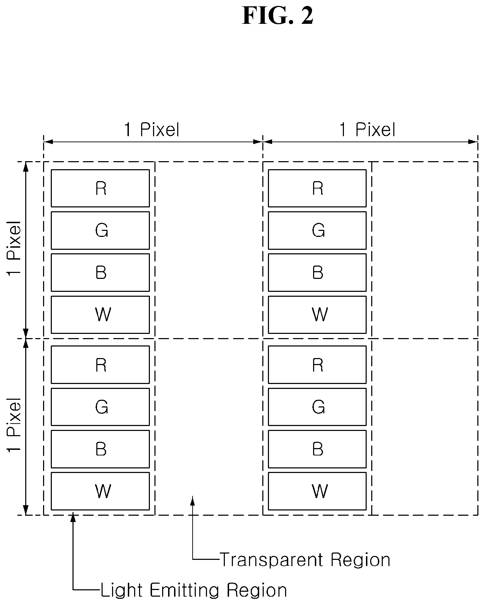

Referring to FIG. 2, a pixel may include a light emitting region and a transparent region. Subpixels of RGBW (Red, Green, Blue, White) may be arranged vertically in the light emitting region, and the transparent region with no subpixels may be disposed next to the light emitting region.

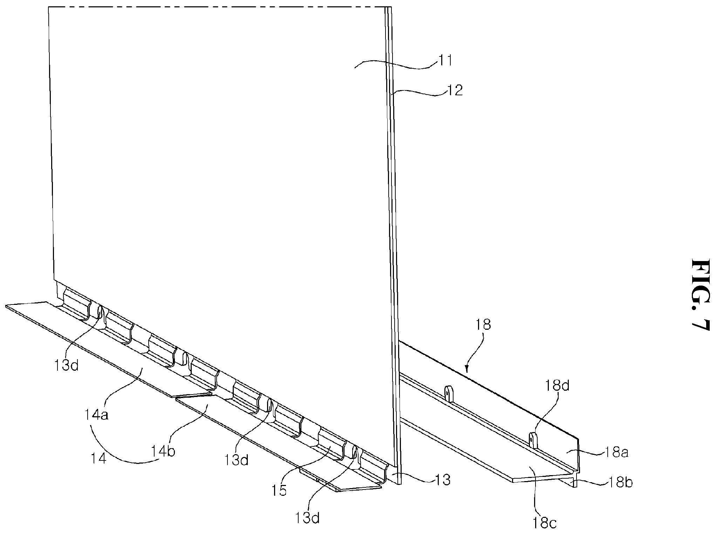

Accordingly, a display panel 11 (see FIG. 7) including a plurality of pixels may not only display an image but also allow light to pass therethrough. The display panel 11 (see FIG. 7) may be referred to as a transparent display panel or a transparent OLED panel.

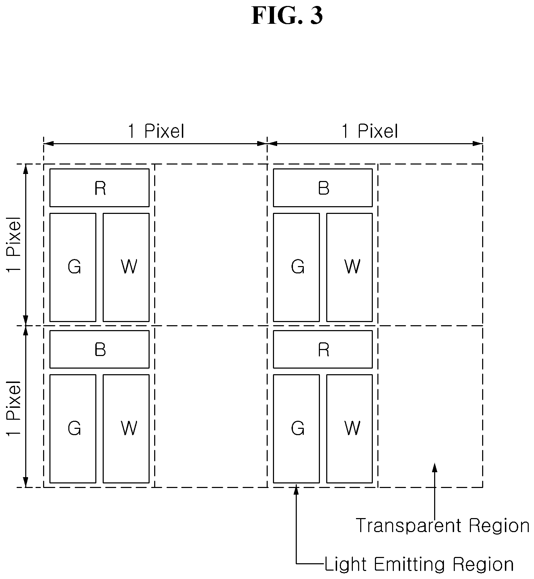

Referring to FIG. 3, a pixel may include a light emitting region and a transparent region. Subpixels of RGW (Red, Green, White) or subpixels of BGW (Blue, Green, White) may be arranged adjacent to each other in the light emitting region, and the transparent region with no subpixels may be disposed next to the light emitting region.

Accordingly, the display panel 11 (see FIG. 7) including a plurality of pixels may not only display an image but also allow light to pass therethrough. The display panel 11 (see FIG. 7) may be referred to as a transparent display panel or a transparent OLED panel.

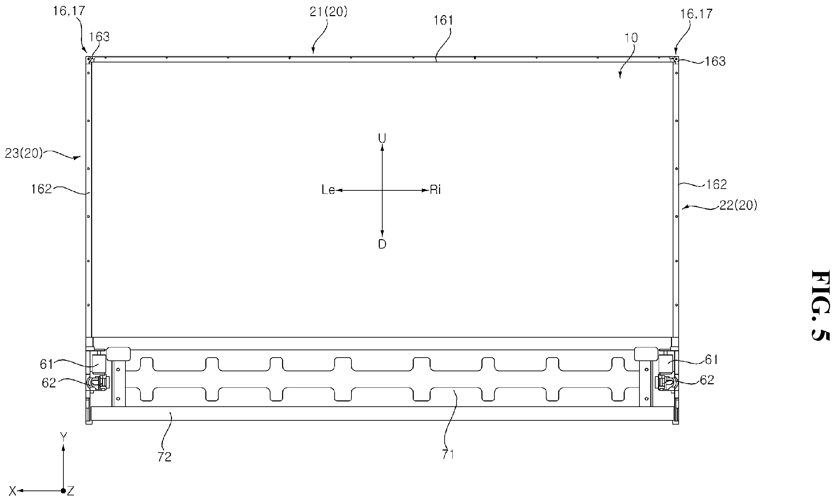

Referring to FIGS. 4 and 5, the display 10 may be coupled to the side frame 20. A housing frame 71 may be coupled or fixed to the side frame 20. The housing frame 71 may cover a rear surface of the display 10. The housing frame 71 may be positioned at the rear of the display 10. The housing frame 71 may be referred to as a rear frame 71, a rear plate 71, or a rear base 71. A length of the housing frame 71 may correspond to a length of the long side of the display 10. A width of the housing frame 71 may be less than a length of the short side of the display 10.

A motor 61 may be provided in plurality. The plurality of motors 61 may be disposed at the rear of the display 10, respectively adjacent to the left side and the right side of the display 10. A pair of motors 61 may provide dual driving force. A gear box 62 may correspond to the motor 61. Each of a plurality of gear boxes 62 may be connected to a corresponding one of the plurality of motors 61. A pair of gear boxes 62 may transmit the dual driving force provided by the pair of motors 62. The motor 61 and/or the gear box 62 may be coupled or fixed to a rear surface of the housing frame 71. The motor 61 and/or the gear box 62 may not be exposed to the front of the display device 10 by the housing frame 71. A bar 40 may move up and down while sliding on the side frame 20.

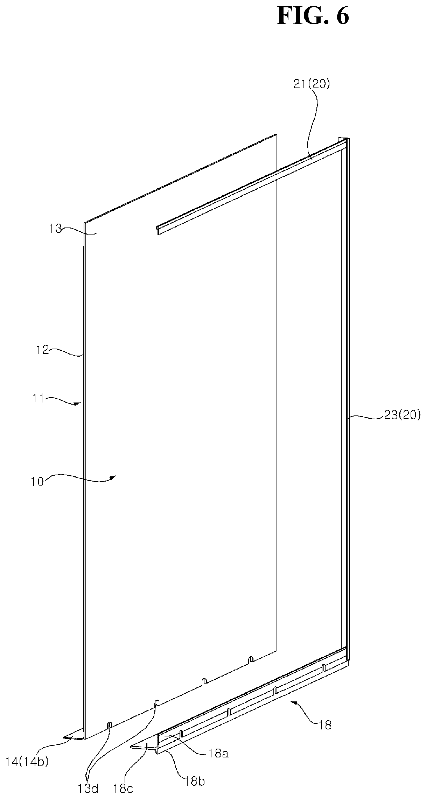

Referring to FIG. 6 in conjunction with FIG. 5, the display 10 may be coupled to the side frame 20. A lower frame 18 may be coupled or fixed to the side frame 20, and may support the display 10 at the lower side of the display 10. The side frame 20 may include a first part 21, a second part 22, and a third part 23.

The first part 21 may be coupled to the upper side of the display 10, the second part 22 may be coupled to the right side of the display 10, and the third part 23 may be coupled to the left side of the display 10. The lower frame 18 may be coupled or fixed to the second part 22 and/or the third part 23 of the side frame 20.

Vertical fixers 162 may be coupled to the second part 22 and the third part 23, respectively, and a horizontal fixer 161 may be coupled to the first part 21. A corner fixer 16 and a pulley 17 may be coupled to the vertical fixer 161 and/or the horizontal fixer 162 at an upper corner.

Referring to FIG. 7 in conjunction with FIG. 6, the display panel 11 may divide an image into a plurality of pixels and output the image by adjusting color, brightness, and saturation for each pixel. The display panel 11 may be divided into an active area AA in which an image is displayed and a de-active area DA in which no image is displayed. The display panel 11 may generate light corresponding to red (R), green (G), or blue (B) in response to a control signal.

A source PCB 14 may be adjacent to a lower side of the display panel 11. The source PCB 14 may extend along the lower side of the display panel 11. The source PCB 14 may be electrically connected to the display panel 11 via a chip on film (COF) 15. The source PCB 14 may be electrically connected to a timing controller board (T-CON board) via a cable (not shown) such as a flexible flat cable (FFC).

A transparent panel 13 may be positioned at the front of the display panel 11. The transparent panel 13 may be formed of transparent glass. An adhesive film 12 may be disposed between the display panel 11 and the transparent panel 13, and may be coupled to the display panel 11 and the transparent panel 13. The adhesive film 12 may be an optically clear adhesive (OCA) film. The transparent panel 13 may be referred to as a front panel 13.

The adhesive film 12 may cover at least a portion of a rear surface of the transparent panel 13. For example, one side of the adhesive film 12 may be positioned closer to the center of the display panel 11 than a corresponding side of the transparent panel 13. A size or an area of the adhesive film 12 may be smaller than a size or an area of the transparent panel 13. For example, an upper side, a left side, and a right side of the adhesive film 12 may be adjacent to an upper side, a left side, and a right side of the transparent panel 13, respectively, and a lower side of the adhesive film 12 may be spaced upward from a lower side of the transparent panel 13.

The size of the adhesive film 12 may correspond to the size of the display panel 11. For example, a diagonal length of the adhesive film 12 may be substantially equal to a diagonal length of the display panel 11. In another example, the diagonal length of the adhesive film 12 may be greater than the diagonal length of the display panel 11. A portion of the adhesive film 12 may be disposed outside the display panel 11 along a periphery of the display panel 11. For example, the adhesive film 12 may form a rectangular line along the periphery of the display panel 11.

The display panel 11, the adhesive film 12, and the transparent panel 13 may be collectively referred to as the display 10.

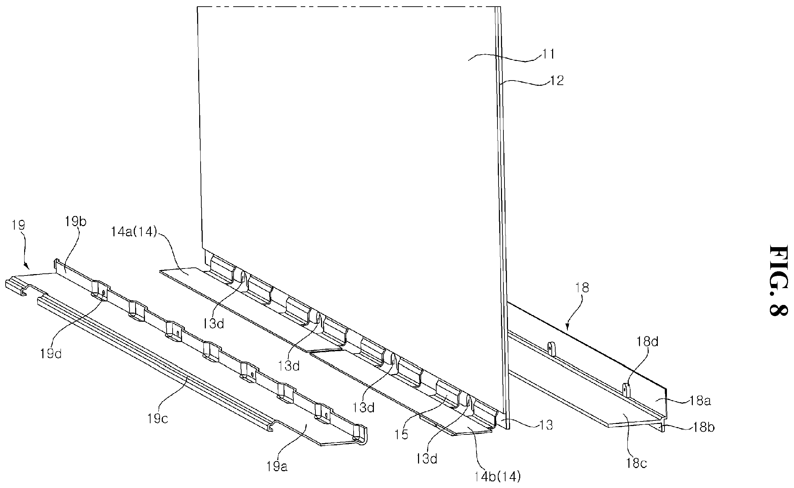

Referring to FIG. 8 in conjunction with FIG. 7, the lower frame 18 may include a horizontal portion 18c, a first vertical portion 18a, a second vertical portion 18b, and a coupling portion 18d. The horizontal portion 18c may be an elongated plate, and the first vertical portion 18a may extend upward from a front edge of the horizontal portion 18c while being perpendicular to the horizontal portion 18c. The second vertical portion 18b may extend downward from the front edge of the horizontal portion 18c while being perpendicular to the horizontal portion 18c. The coupling portion 18d may protrude from a rear surface of the first vertical portion 18a. The coupling portion 18d may be formed on an upper surface of the horizontal portion 18c and/or the rear surface of the first vertical portion 18a. A plurality of coupling portions 18d may be disposed at regular intervals.

The transparent panel 13 may have a coupling groove 13d formed by removing a portion from the lower side of the transparent panel 13. The coupling groove 13d of the transparent panel 13 may correspond to the coupling portion 18d of the lower frame 18. The coupling portion 18d of the lower frame 18 may be inserted into the coupling groove 13d of the transparent panel 13. The first vertical portion 18a may cover a portion of a front surface of the transparent panel 13 adjacent to the lower side of the transparent panel 13. The horizontal portion 18c of the lower frame 18 may support the transparent panel 13.

The source PCB 14 may be positioned on the horizontal portion 18c of the lower frame 18. The source PCB 14 may face or contact the horizontal portion 18c of the lower frame 18.

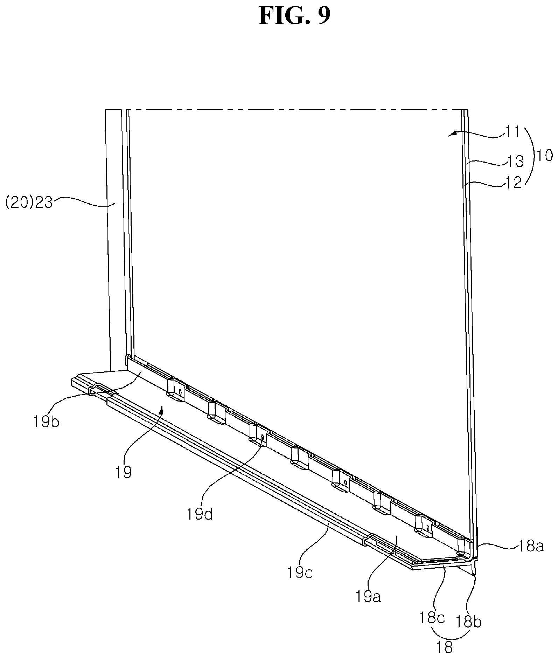

Referring to FIG. 9 in conjunction with FIG. 8, a PCB cover 19 may include a horizontal portion 19a, a folding portion 19c, a vertical portion 19b, and a fixing portion 19d. The horizontal portion 19a may be an elongated plate, and may cover the source PCB 14. The vertical portion 19b may extend upward from an edge of the horizontal portion 19a or may be bent therefrom. The folding portion 19c may be positioned opposite the vertical portion 19b with respect to the horizontal portion 19a. The folding portion 19c may be bent and extend from the horizontal portion 19a toward a lower surface of the horizontal portion 19a. The folding portion 19c may face the horizontal portion 19a. The fixing portion 19d may be formed on the vertical portion 19b. The fixing portion 19d may be formed by protruding forward from the vertical portion 19b as the vertical portion 19b is pressed. The fixing portion 19d may be fixed to the coupling portion 18d of the lower frame 18.

When the folding portion 19c of the PCB cover 19 is coupled to the horizontal portion 18c of the lower frame 18 and the fixing portion 19d of the PCB cover 19 is fixed to the coupling portion 18d of the lower frame 18, the PCB cover 19 may cover the source PCB 14.

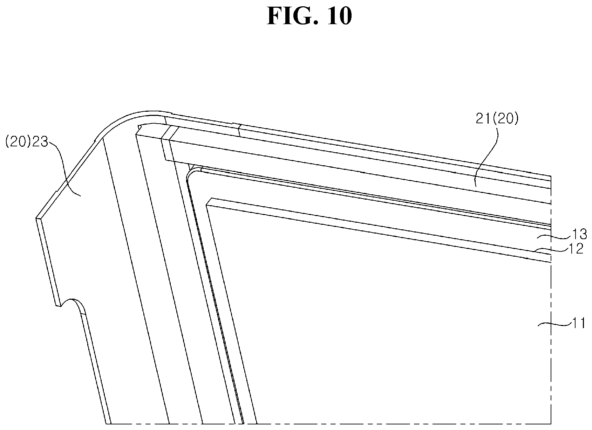

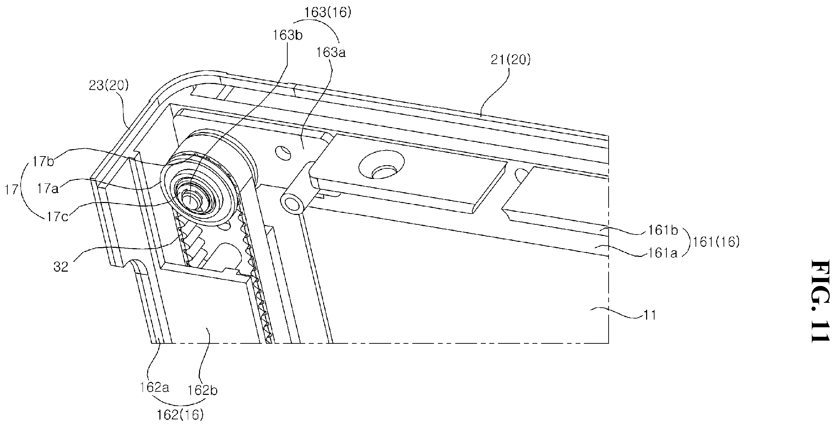

Referring to FIGS. 10 and 11, the display panel 11 may be disposed on the rear surface of the transparent panel 13. The display panel 11 may be attached or fixed to the adhesive film 12.

A frame fixer 16 may include a horizontal fixer 161, a vertical fixer 162, and a corner fixer 163. The horizontal fixer 161 may be integrally formed with the vertical fixer 162. The horizontal fixer 161 and the vertical fixer 162 may be collectively referred to as an inner frame (161, 162). The horizontal fixer 161 may include a plate 161a and a wall 161b. The plate 161a may be elongated horizontally, and may be fixed to the first part 21 of the side frame 20. The wall 161b may be formed on the plate 161a. The wall 161b may protrude rearward from an outer surface of the plate 161a.

The vertical fixer 162 may include a plate 162a and a wall 162b. The plate 162a may be elongated vertically, and may be fixed to the third part 23 of the side frame 20. The wall 162b may be formed on the plate 162a. The wall 162b may protrude horizontally from an outer surface of the plate 162a.

The corner fixer 163 may be a bent plate segment. The corner fixer 163 may be a plate 163a bent along a corner between the vertical fixer 162 and the horizontal fixer 161. A pulley shaft 163b may protrude and extend from an outer surface of the plate 163a of the corner fixer 163 toward the rear of the transparent panel 13. The corner fixer 163 may be attached or fixed to the horizontal fixer 161 and/or the vertical fixer 162. The corner fixer 163 may be referred to as a left corner fixer 163 or a first corner fixer 163. When the corner fixer 163 is positioned at a corner formed by the first part 21 and the second part 22 of the side frame 20 (see FIG. 5), the corner fixer 163 may be referred to as a right corner fixer 163 or a second corner fixer 163.

The pulley 17 may be inserted onto the pulley shaft 163b. The pulley 17 may rotate about the pulley shaft 163b. The pulley 17 may be referred to as an upper pulley 17. For example, a lubricant may be applied between the pulley shaft 163b and the pulley 17 to prevent noise. In another example, the pulley 17 may be formed of a synthetic resin having low frictional resistance, and the pulley shaft 163b may include metal to prevent noise and facilitate smooth rotation of the pulley 17. A belt 32 may be wound around the pulley 17.

The pulley 17 may include a wheel 17a and a belt gear 17b. The wheel 17a may be formed in a ring or rim shape. The pulley shaft 163b may be inserted into the wheel 17a, and the wheel 17a may rotate about the pulley shaft 163b. The belt gear 17b may form an outer circumferential surface of the wheel 17a. A retaining washer 17c may be coupled to the pulley shaft 163b at a position adjacent to an end of the pulley shaft 163b. For example, the retaining washer 17c may be an E-ring. The retaining washer 17c may prevent the pulley 17 from being separated from the pulley shaft 163b. A first pulley 17 or a left pulley 17 may be positioned at the first corner fixer 163 or the left corner fixer 163, and a second pulley 17 (see FIG. 5) or a right pulley 17 (see FIG. 5) may be positioned at the second corner fixer 163 or the right corner fixer 163.

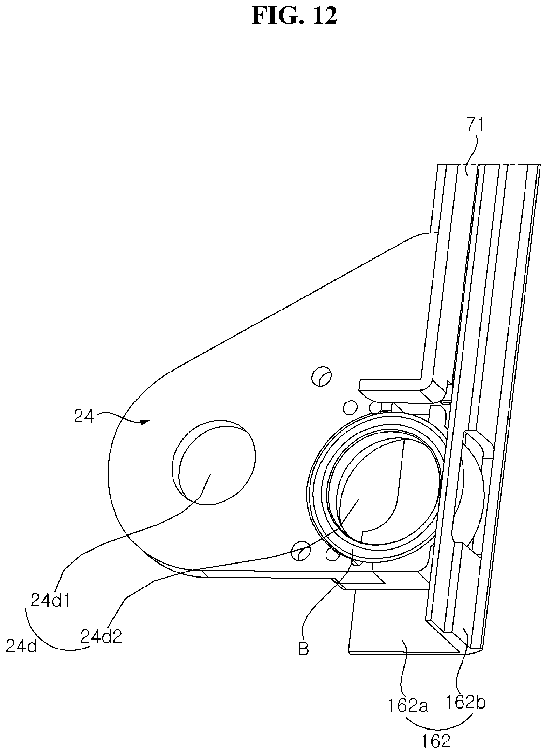

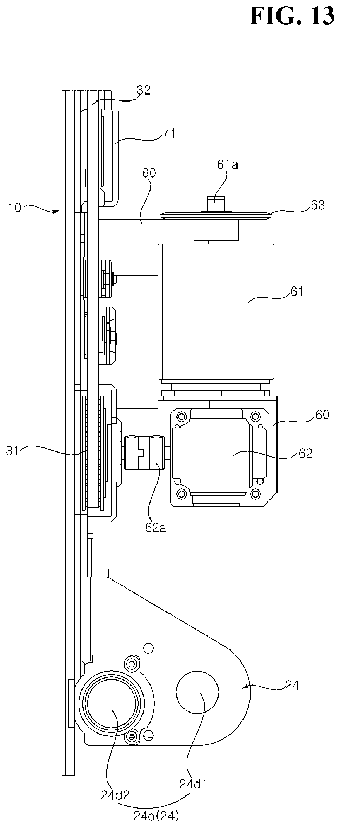

Referring to FIGS. 12 and 13, a mount bracket 24 may be coupled or fixed to the plate 162a of the vertical fixer 162, and may be supported by the wall 162b of the vertical fixer 162. The mount bracket 24 may be coupled or fixed to the wall 162b of the vertical fixer 162, and may be supported by the plate 162a of the vertical fixer 162.

The mount bracket 24 may include a main roller hole 24d1 and a sub roller hole 24d2. The sub roller hole 24d2 may face or overlap the plate 162a of the vertical fixer 162. The main roller hole 24d1 may be adjacent to the sub roller hole 24d2. A bearing B may be mounted in the main roller hole 24d1 and/or the sub roller hole 24d2.

A fixing bracket 60 may be coupled to the vertical fixer 162 or the housing frame 71. The fixing bracket 60 may be integrally formed with the housing frame 71. The motor 61 and/or the gear box 62 may be coupled to the fixing bracket 60. The motor 61 may provide rotational force, and the gear box 62 may be connected to the motor 61 to transmit driving force. A rotation counter 63 may be fixed to a motor shaft 61a so as to rotate together with the motor shaft 61a.

A joint 62a may be connected to the gear box 62 and may rotate by receiving the driving force from the gear box 62. An axial direction of the joint 62a may be parallel to a thickness direction of the display 10. A driving pulley 31 may be fixed to the joint 62a so as to rotate together with the joint 62a. The belt 32 may be wound around the driving pulley 31. The belt 32 may be referred to as a driving belt 32 or a timing belt 32. The driving pulley 31 may be referred to as a lower pulley 31, a main pulley 31, or a suspending pulley 31.

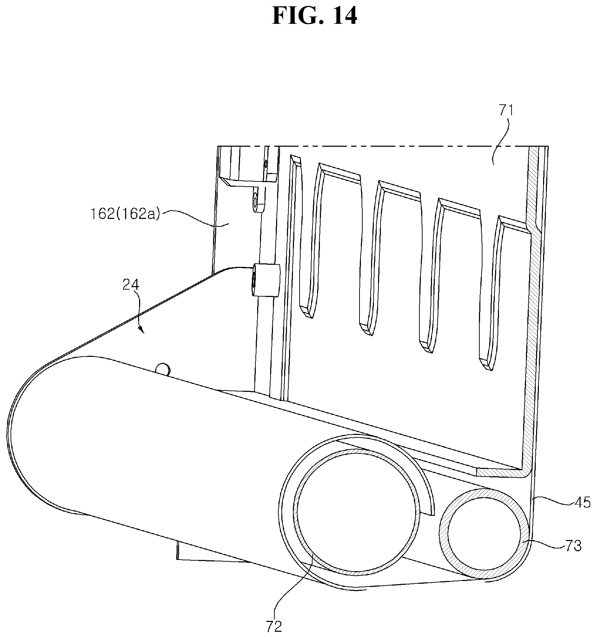

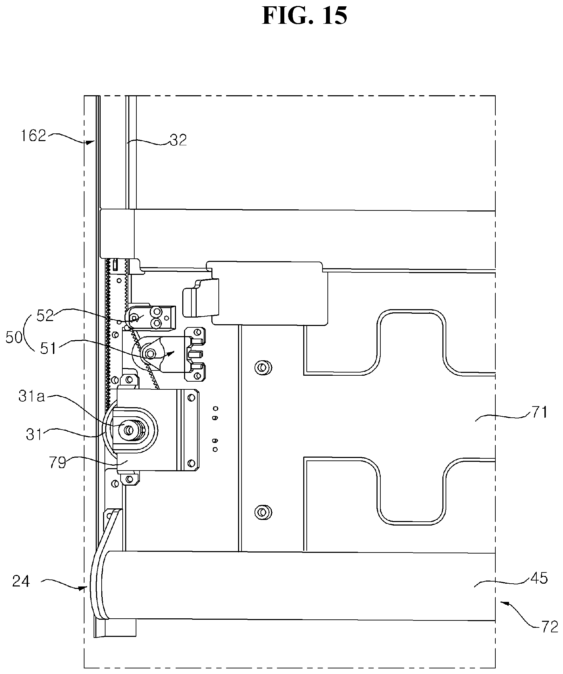

Referring to FIGS. 14 and 15, a main roller 72 may be coupled to or inserted into the main roller hole 24d1 (see FIG. 13) of the mount bracket 24 to rotate. A sub roller 73 may be coupled to or inserted into the sub roller hole 24d2 (see FIG. 13) of the mount bracket 24 to rotate. A light-shielding film 45 may be wound around the main roller 72, and may be supported by the sub roller 73. The light-shielding film 45 may be unwound from the main roller 72 and guided by the sub roller 73 to move toward a front surface of the housing frame 71. The light-shielding film 45 unwound from the main roller 72 may cover the front surface of the housing frame 71.

A pulley mount 79 may be coupled to a rear surface of the housing frame 71. The pulley mount 79 may be a bracket or a plate. The pulley mount 79 may be integrally formed with the housing frame 71. The driving pulley 31 may rotate on the pulley mount 79. A shaft 31a of the driving pulley 31 may be inserted into the pulley mount 79, and may be aligned by the pulley mount 79. For example, the driving pulley 31 may rotate on the pulley mount 79 but may not move in the up-down direction or the left-right direction.

A sub pulley 50 may be a tensioner 50. The sub pulley 50 may be positioned above the pulley mount 79, and may push the belt 32. The belt 32 may maintain a constant tension by the sub pulley 50. The sub pulley 50 may include a plurality of sub pulleys 51 and 52.

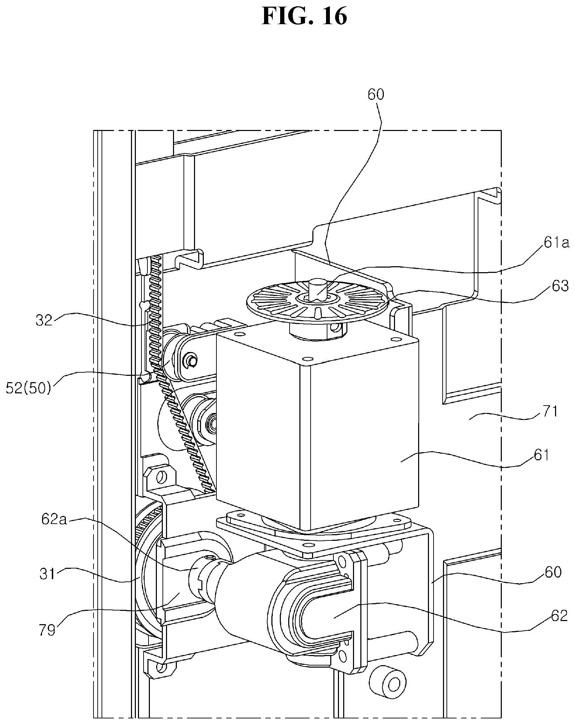

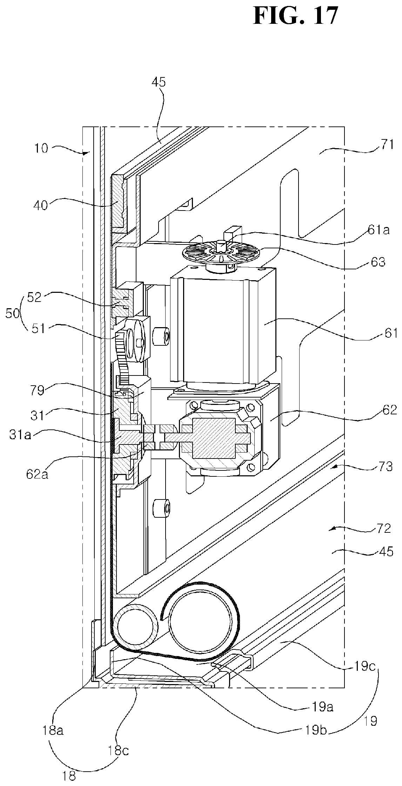

Referring to FIGS. 16 and 17 in conjunction with FIG. 15, the driving force provided by the motor 61 may be transmitted to the driving pulley 31 via the gear box 62. The driving pulley 31 may rotate on the pulley mount 79. As the driving pulley 31 rotates, the belt 32 may move in the up-down direction, and the belt 32 may maintain a constant tension by the sub pulley 50.

The lower frame 18 to which the PCB cover 19 is coupled may be positioned below the housing frame 71. The main roller 72 and the sub roller 73 may be positioned on the lower frame 18, and may be positioned at the rear of the housing frame 71. The light-shielding film 45 may be wound around and unwound from the main roller 72, and may be guided by the sub roller 73 to cover the front surface of the housing frame 71.

An end of the light-shielding film 45 may be fixed to the bar 40. As the belt 32 fixed to one end of the bar 40 moves, the bar 40 may move in the up-down direction. As the bar 40 moves, the light-shielding film 45 may cover the rear surface of the display 10. The bar 40 may be positioned behind the rear surface of the display 10, and may move in the up-down direction of the display 10.

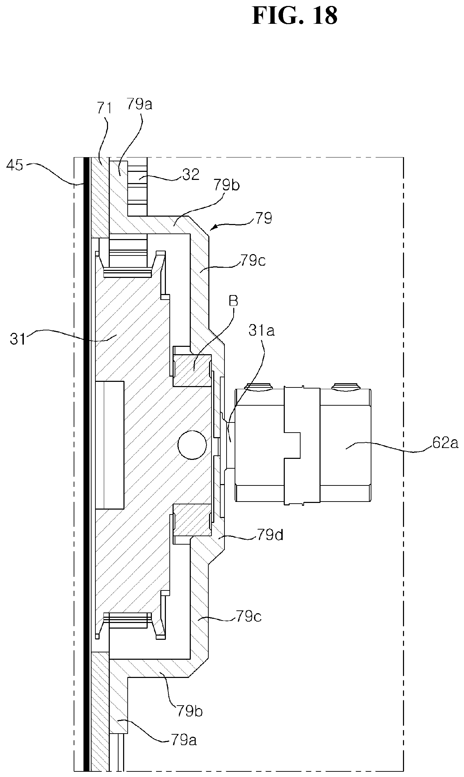

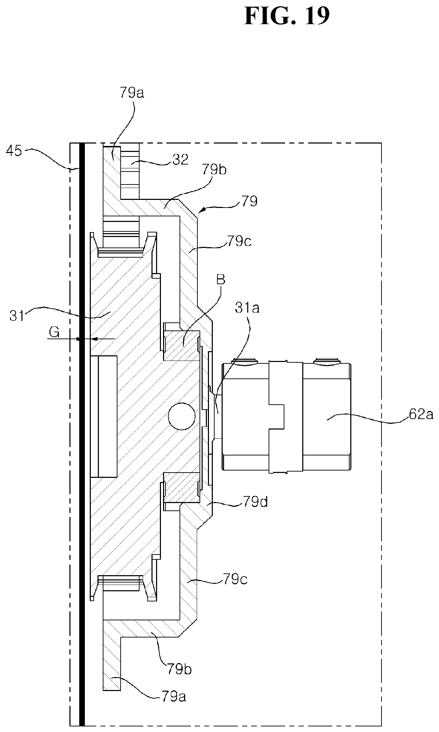

Referring to FIGS. 18 and 19, the pulley mount 79 may include a flange portion 79a, a pulley housing 79b, a bearing mount 79c, and a shaft mount 79d. The flange portion 79a having a disc shape may be fixed to the rear surface of the housing frame 71. The pulley housing 79b may define a space in which the driving pulley 31 is accommodated. A diameter of the pulley housing 79b may be greater than a diameter of the driving pulley 31, and a height of the pulley housing 79b may be greater than a thickness of the driving pulley 31.

A bearing B may be fixed to the bearing mount 79c. The pulley shaft 31a may penetrate from the inside to the outside of the pulley mount 79 through the shaft mount 79d. The driving pulley 31 may be coupled to the bearing B and may rotate within the pulley housing 79b. The pulley shaft 31a may be coupled to the joint 62a so as to rotate together with the joint 62a.

A front surface of the driving pulley 31 may be spaced apart from the light-shielding film 45. A predetermined gap G may be formed between the front surface of the driving pulley 31 and a rear surface of the light-shielding film 45. Accordingly, the belt 32 may be moved by rotation of the driving pulley 31 without a structure passing through the light-shielding film 45.

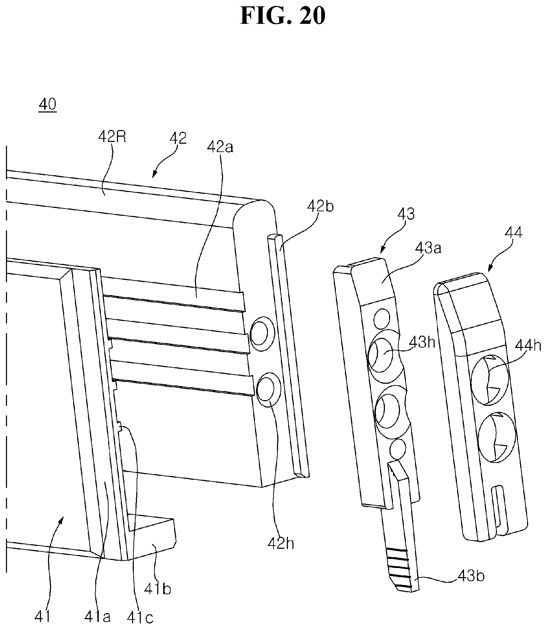

Referring to FIG. 20, the bar 40 may include a first piece 41, a second piece 42, a belt fixer 43, and a fixer cover 44. The first piece 41 and the second piece 42 may be coupled to each other. The first piece 41 may include a first part 41a and a second part 41b. The first part 41a may be in the shape of an elongated plate bar. The second part 41b may extend in a thickness direction of the first part 41a to form a wall at an edge of the first part 41a. A fixing rib 41c may be formed on one surface of the first part 41a. The fixing rib 41c may be elongated in a longitudinal direction of the first part 41a. A plurality of fixing ribs 41c may be provided. The plurality of fixing ribs 41c may be spaced apart from each other by a predetermined distance.

The second piece 42 may have a plate bar shape extending to a length corresponding to the first piece 41. A rib groove 42a may be formed on one surface of the second piece 42 in a manner of extending in a longitudinal direction of the second piece 42. A plurality of rib grooves 42a may be provided, and the plurality of rib grooves 42a may be arranged on one surface of the second piece 42a to correspond to the plurality of fixing ribs 41c. A side rib 42b may be formed on an end surface of the second piece 42 in a width direction of the second piece 42. A fastening hole 42h may be formed in the end surface of the second piece 42 at a position adjacent to the side rib 42b. The fastening hole 42h may be provided in plurality. An edge 42R of the second piece 42 in a longitudinal direction of the second piece 42 may be rounded.

The belt fixer 43 may be coupled to end surfaces of the first piece 41 and the second piece 42. The belt fixer 43 may have a fastening hole 43h. The fastening hole 43h of the belt fixer 43 may correspond to the fastening hole 42h of the second piece 42. The fastening hole 43h may be provided in plurality.

The fixer cover 44 may be coupled to the belt fixer 43. The fixer cover 44 may have an insertion hole 44h. The insertion hole 44h may correspond to the fastening hole 43h of the belt fixer 43. The insertion hole 44h may be provided in plurality.

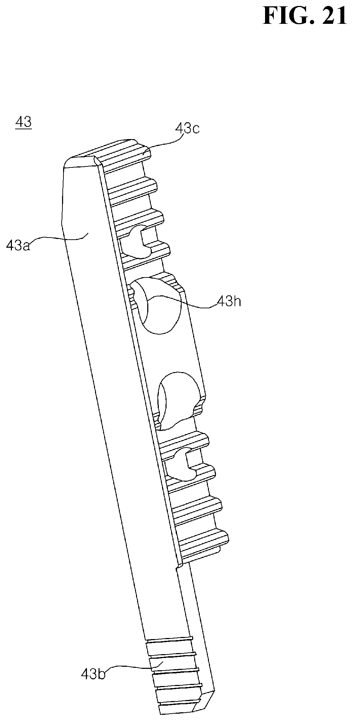

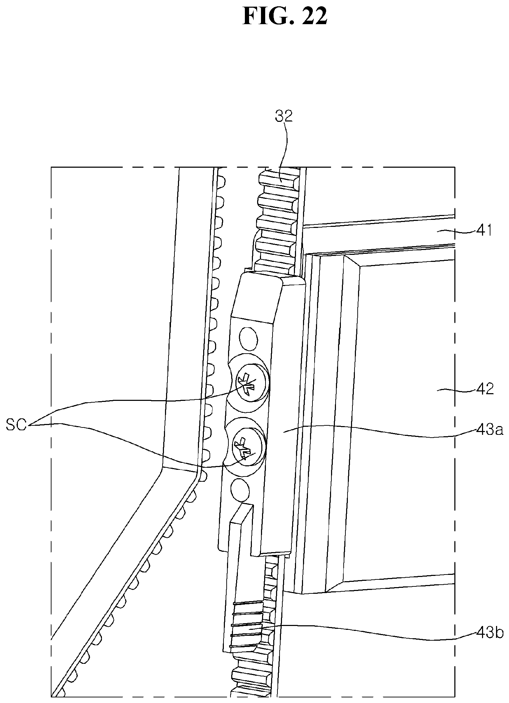

Referring to FIGS. 21 and 22, the belt fixer 43 may include a fixer body 43a and a fixer tail 43b. The fixer body 43a may be elongated, and may have fastening holes 43h. A gear surface 43c may be formed on one surface of the fixer body 43a. The fixer tail 43b may extend from one end of the fixer body 43a in a longitudinal direction of the fixer body 43a. The fixer tail 43b may serve as an indicator of a position of the bar 40 (see FIG. 20).

The belt fixer 43 may be coupled to one end surface of the bar 40 while pressing the belt 32. A gear of the belt 32 and the gear surface 43c of the belt fixer 43 may be engaged with each other. A screw SC may be inserted into the fastening hole 43h to fix the belt fixer 43 to the one end surface of the bar 40 (see FIG. 20). Accordingly, slip of the belt 32 may be prevented, thereby enabling more precise vertical movement of the bar 40 (see FIG. 20).

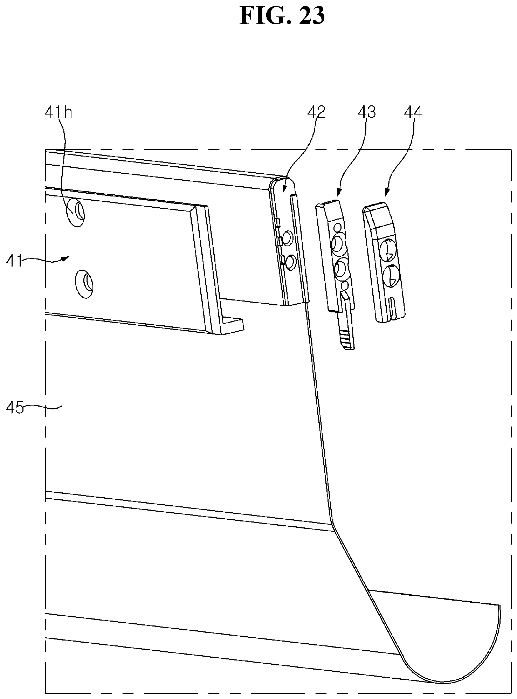

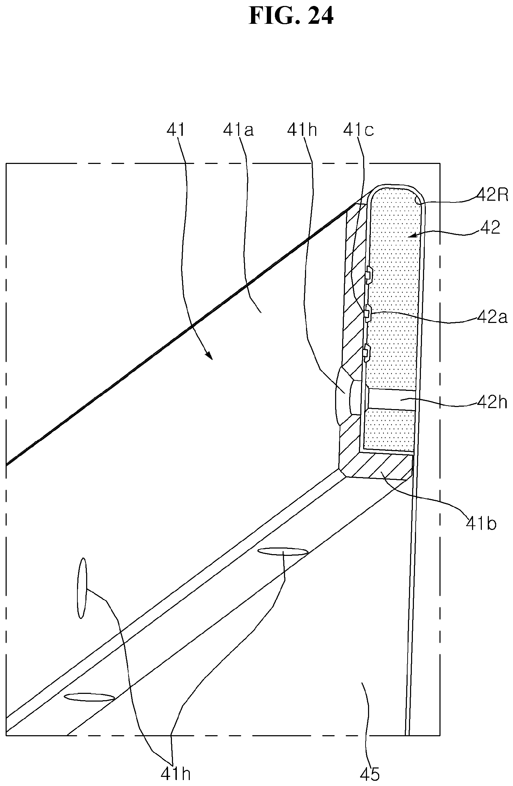

Referring to FIGS. 23 and 24, the light-shielding film 45 may be wound around the bar 40. The light-shielding film 45 may cover an outer surface of the second piece 42, may be wound around the rounded edge 42R, and may be inserted between the first piece 41 and the second piece 42. The light-shielding film 45 may be in contact with the first piece 41 and the second piece 42. The light-shielding film 45 may be positioned between the fixing rib 41c and the rib groove 42a. The fixing rib 41c may be inserted into the rib groove 42a to hold the light-shielding film 45. As the light-shielding film 45 is wound around the rounded edge 42R of the second piece 42, taut tension may be provided to the light-shielding film 45.

An end of the light-shielding film 45 may be positioned between the first part 41a of the first piece 41 and the second piece 42. The end of the light-shielding film 45 may also be positioned between the second part 41b of the first piece 41 and the second piece 42. When the end of the light-shielding film 45 is positioned between the second part 41b of the first piece 41 and the second piece 42, the light-shielding film 45 may be more firmly fixed to the bar 40.

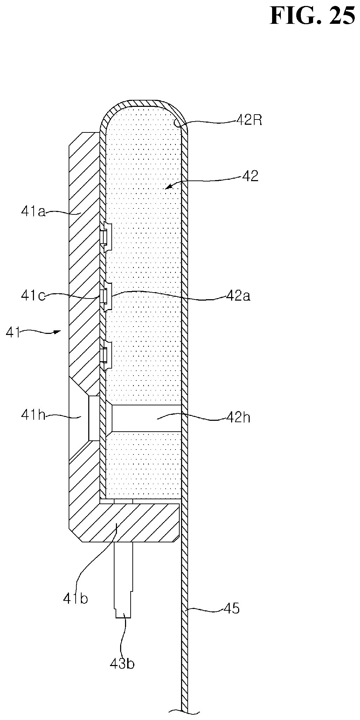

Referring to FIG. 25 in conjunction with FIG. 24, the second piece 42 may include a horizontal fastening hole 42h. The horizontal fastening hole 42h may be formed through the second piece 42 in a thickness direction of the second piece 42. The first part 41a of the first piece 41 may include a horizontal fastening hole 41h. The horizontal fastening hole 41h of the first piece 41 may correspond to the horizontal fastening hole 42h of the second piece 42. A fastening member may be inserted into the horizontal fastening hole 42h of the second piece 42 through the horizontal fastening hole 41h of the first piece 41 and may be fixed thereto. In this case, a screw may pass through the light-shielding film 45. As the screw passes through the light-shielding film 45, wrinkles may be formed in the light-shielding film 45. The wrinkles of the light-shielding film 45 may be suppressed by insertion of the fixing rib 41c into the rib groove 42a.

Accordingly, the light-shielding film 45 may be firmly fixed to the bar 40, sufficient tension may be applied to the light-shielding film 45, and wrinkling of the light-shielding film 45 may be prevented.

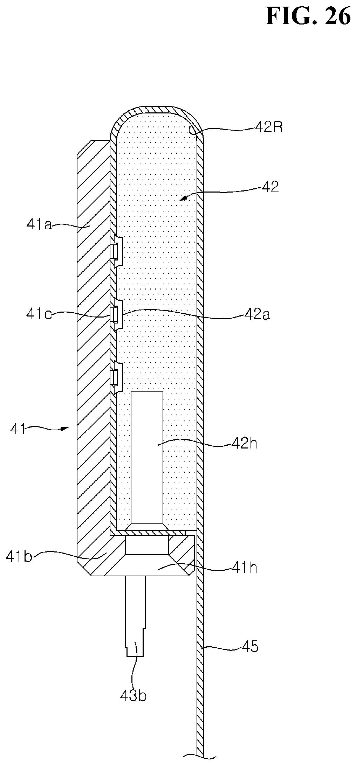

Referring to FIG. 26 in conjunction with FIG. 24, the second piece 42 may include a vertical fastening hole 42h. The vertical fastening hole 42h may be formed to extend in a width direction of the second piece 42 into the second piece 42. The second part 41b of the first piece 41 may include a vertical fastening hole 41h. The vertical fastening hole 41h of the first piece 41 may correspond to the vertical fastening hole 42h of the second piece 42. A fastening member may be inserted into the vertical fastening hole 42h of the second piece 42 through the vertical fastening hole 41h of the first piece 41 and may be fixed thereto. In this case, a screw may pass through the light-shielding film 45. As the screw passes through the light-shielding film 45, wrinkles may be formed in the light-shielding film 45. The wrinkles of the light-shielding film 45 may be suppressed by insertion of the fixing rib 41c into the rib groove 42a.

Accordingly, the light-shielding film 45 may be firmly fixed to the bar 40, sufficient tension may be applied to the light-shielding film 45, and wrinkling of the light-shielding film 45 may be prevented.

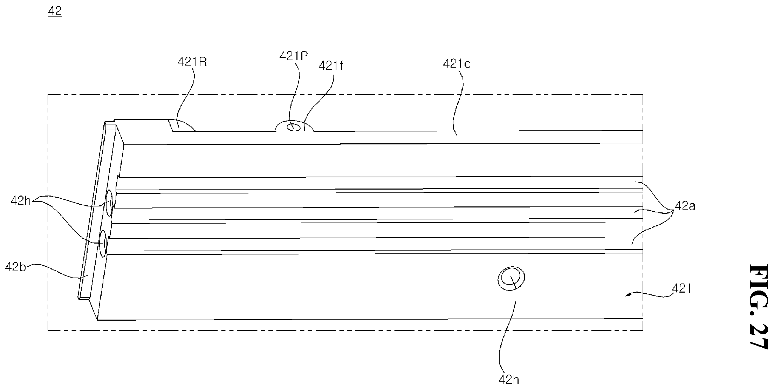

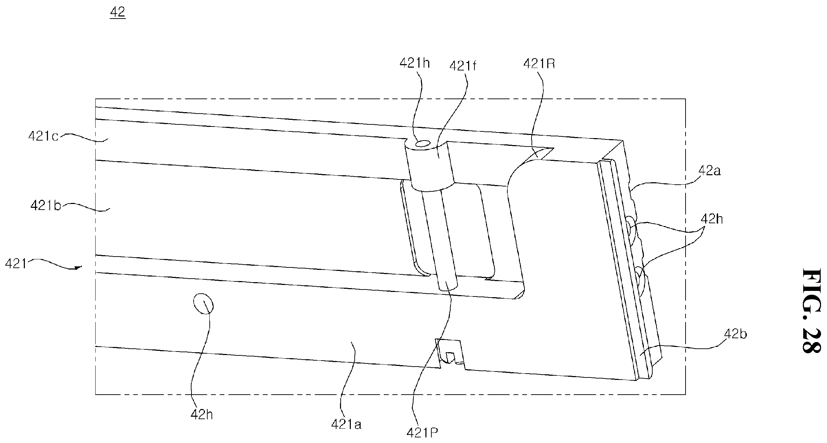

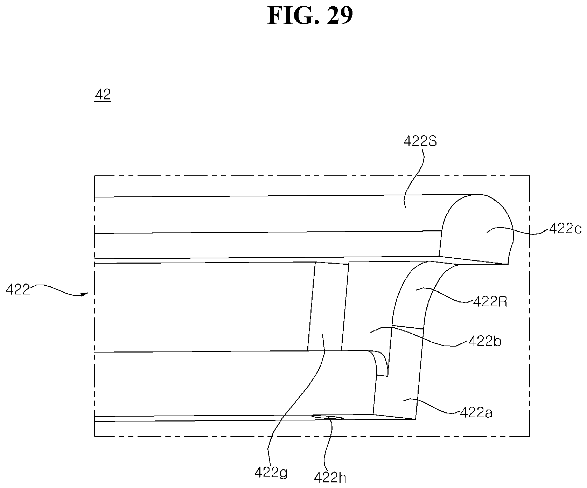

Referring to FIGS. 27 and 28, the second piece 42 of the bar 40 (see FIG. 20) may include a lower piece 421 and un upper piece 422 (see FIG. 29). The lower piece 421 may have a plate bar shape extending to a length corresponding to the first part 41a (see FIG. 20) of the first piece 41 (see FIG. 20).

A rib groove 42a may be formed on one surface of the lower piece 421 in a manner of extending in a longitudinal direction of the lower piece 421. A plurality of rib grooves 42a may be provided, and the plurality of rib grooves 42a may be arranged on the one surface of the lower piece 421 corresponding to the plurality of fixing ribs 41c (see FIG. 20). A side rib 42b may extend in a width direction of the lower piece 421, and may be formed on an end surface of the lower piece 421. A fastening hole 42h may be formed in the end surface of the lower piece 421 at a position adjacent to the side rib 42b. A plurality of fastening holes 42h may be provided.

An up-down pole 421P may be coupled to the lower piece 421. The up-down pole 421P may be referred to as an up-down guide 421P, a guide pole 421P, or a moving guide 421P. The up-down pole 421P may be positioned opposite the rib groove 42a with respect to the lower piece 421. The up-down pole 421P may be an elongated rod.

The lower piece 421 may include a base part 421a, a wall part 421b, and a high-end part 421c. The base part 421a may form a lower portion of the lower piece 421. The base part 421a may define a greatest thickness of the lower piece 421. A horizontal fastening hole 42h may be formed through the base part 421a in a thickness direction of the base part 421a.

The wall part 421b may be connected to the base part 421a. The rib groove 42a may be formed on one surface of the wall part 421b. A thickness of the wall part 421b may be less than a thickness of the base part 421a. The wall part 421b may form a step with respect to the base part 421a. The step between the wall part 421b and the base part 421a may be positioned opposite the rib groove 42a with respect to the wall part 421b.

The high-end part 421c may be connected to the wall part 421b. A thickness of the high-end part 421c may be greater than the thickness of the wall part 421b and less than the thickness of the base part 421a. A step may be formed between the high-end part 421c and the wall part 421b. The step between the high-end part 421c and the wall part 421b may face the step between the wall part 421b and the base part 421a. A pole fixing portion 421f may be formed on the high-end part 421c.

The up-down pole 421P may pass through the base part 421a in a width direction of the lower piece 421 and may be inserted into the pole fixing portion 421f of the high-end part 421c. The up-down pole 421P may be spaced apart from the wall part 421b and may face the wall part 421b.

At both ends of the lower piece 421, the base part 421a may be connected to the high-end part 421c. The base part 421a may extend while maintaining its thickness and may be connected to the high-end part 421c. An inner side of the base part 421a connected to the high-end part 421c may be rounded (421R).

Referring to FIGS. 29 to 31, the upper piece 422 may include a lower end part 422a, a middle part 422b, and a top part 422c. The lower end part 422a may be connected to a lower side of the middle part 422b, and the top part 422c may be connected to an upper side of the middle part 422b. The lower end part 422a may be positioned opposite the top part 422c with respect to the middle part 422b.

A thickness of the lower end part 422a may be greater than a thickness of the middle part 422b. A thickness of the top part 422c may be greater than the thickness of the middle part 422b and may be greater than the thickness of the lower end part 422a. The top part 422c may include a rounded surface 422s.

A pole accommodating portion 422g may be formed in the middle part 422b. The pole accommodating portion 422g may be formed as the middle part 422b is cut into a half-pipe shape. The pole accommodating portion 422g may have a longitudinal direction from the lower end part 422a toward the top part 422c and may have a radial direction toward the inside of the middle part 422b.

A pole insertion hole 422h may be formed in the lower end part 422a. The pole insertion hole 422h may pass through the lower end part 422a from the lower end part 422a toward the middle part 422b. The pole insertion hole 422h may be aligned with the pole accommodating portion 422g. A diameter of the pole insertion hole 422h may be less than a diameter of the pole accommodating portion 422g.

Both ends of the middle part 422b may have a curved part 422R. The curved part 422R may be recessed to the inside of the middle part 422b. The curved part 422R of the upper piece 422 may correspond to the rounded surface 421R of the base part 421a of the lower piece 421.

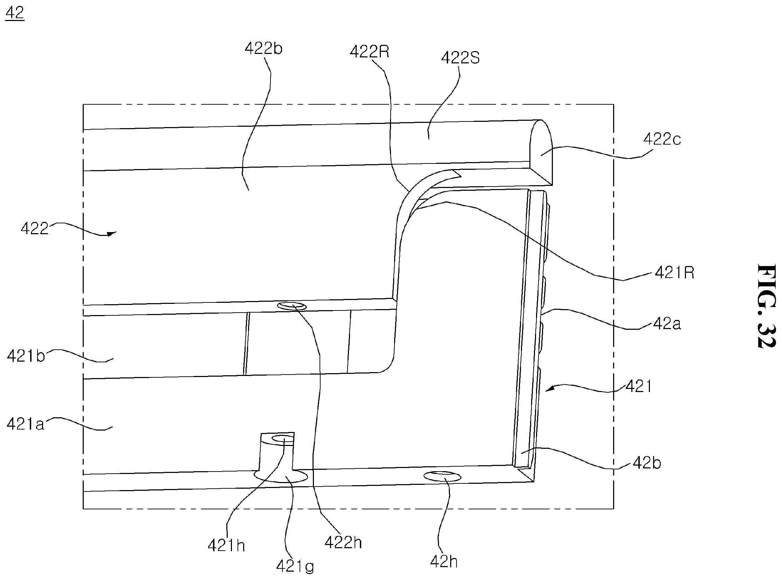

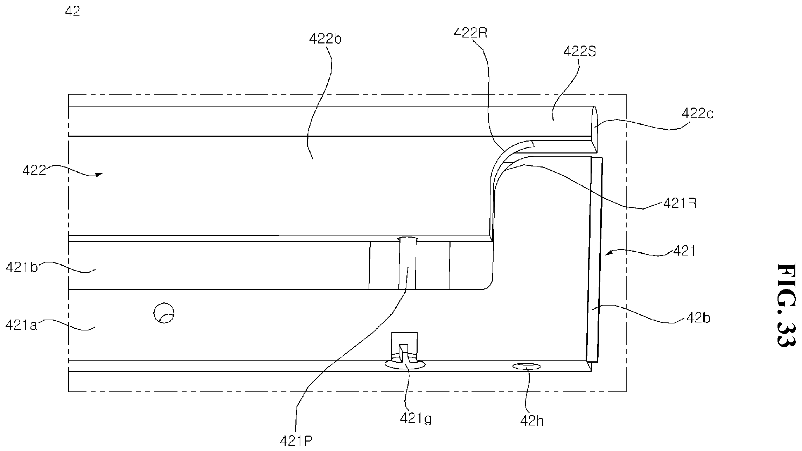

Referring to FIGS. 32 and 33, a pole insertion hole 421h may be formed in the base part 421a of the lower piece 421. The pole insertion hole 421h may pass through the base part 421a of the lower piece 421 in a width direction of the bar 40 (see FIG. 20). A pole head groove 421g may be aligned with the pole insertion hole 421h in a longitudinal direction of the pole insertion hole 421h, and may be formed in the base part 421a. The pole head groove 421g and the pole insertion hole 421h may be connected in series.

The upper piece 422 may be coupled to the lower piece 421. The upper piece 422 may reciprocate linearly in the width direction of the bar 40 with respect to the lower piece 421.

The up-down pole 421p may be inserted into the pole insertion hole 421h of the lower piece 421 to pass through the lower piece 421, and may be inserted into the pole insertion hole 422h of the upper piece 422. A head of the up-down pole 421p may be positioned in the pole head groove 421g of the lower piece 421. The up-down pole 421p may limit a movement direction of the upper piece 422. The upper piece 422 may move linearly with respect to the lower piece 421 by the up-down pole 421p.

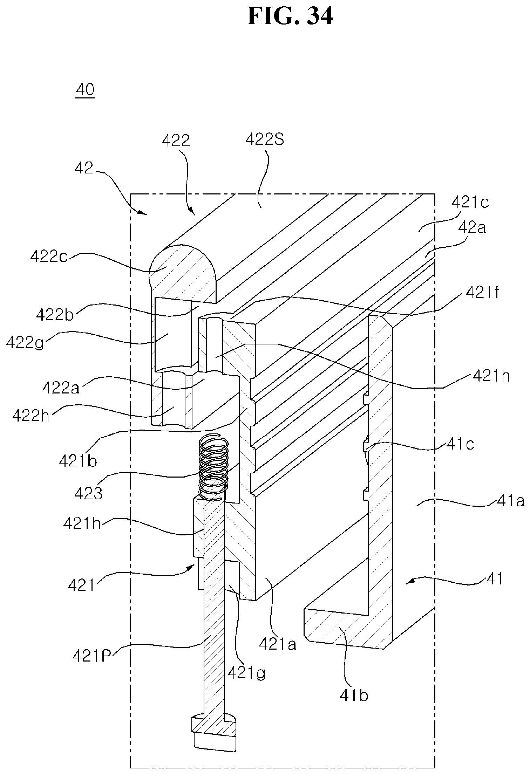

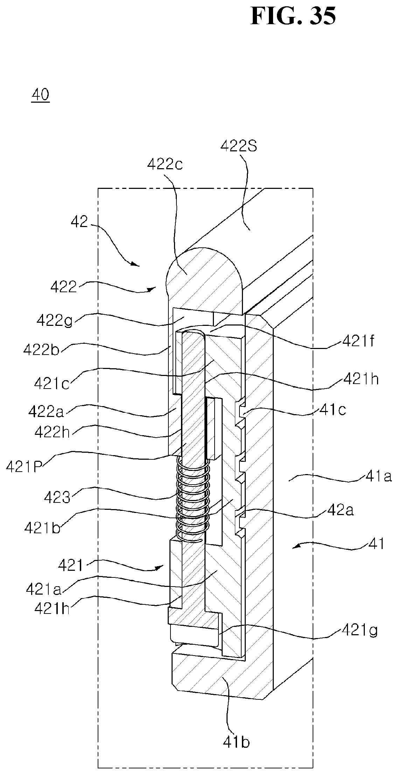

Referring to FIGS. 34 and 35, the upper piece 422 of the second piece 42 may be coupled to the lower piece 421. The upper piece 422 may at least partially overlap the lower piece 421. A portion of the upper piece 422 may face a portion of the lower piece 421. The upper piece 422 and the lower piece 421 may be coupled to form a thickness of the second piece 42.

The up-down pole 421p may be inserted into the pole insertion hole 421h of the lower piece 421. When the head of the up-down pole 421p is positioned in the pole head groove 421g, the up-down pole 421p may pass through the pole insertion hole 422h of the upper piece 422 and may be inserted into the pole insertion hole 422h of the lower piece 421 to be coupled or fixed to the lower piece 421.

The up-down pole 421p may be inserted into an elastic member 423, and the elastic member 423 may be positioned between the upper piece 422 and the lower piece 421. An upper end of the elastic member 423 may support the upper piece 422, and a lower end of the elastic member 423 may support the lower piece 421.

The upper piece 422 may move vertically with respect to the lower piece 421. The upper piece 422 may have a movement direction limited by the up-down pole 421p, and may receive a force in a direction away from the lower piece 421 by the elastic member 423.

The first piece 41 may be coupled to the lower piece 421 of the second piece 42. The first part 41a of the first piece 41 may face the rib groove 42a of the lower piece 421. The fixing rib 41c may be inserted into the rib groove 42a. The second part 41b of the first piece 41 may cover the pole head groove 421g of the lower piece 421 and/or the head of the up-down pole 421p.

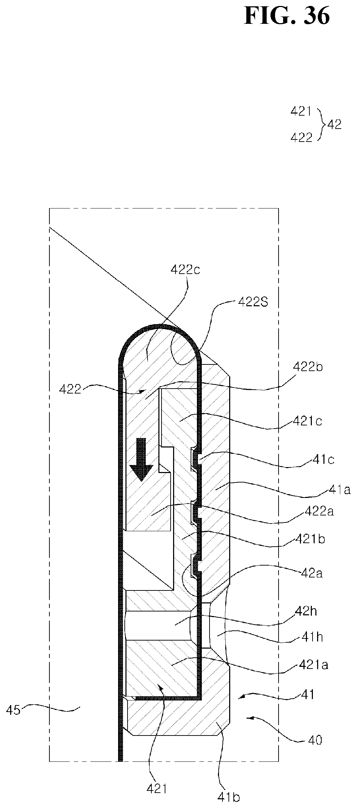

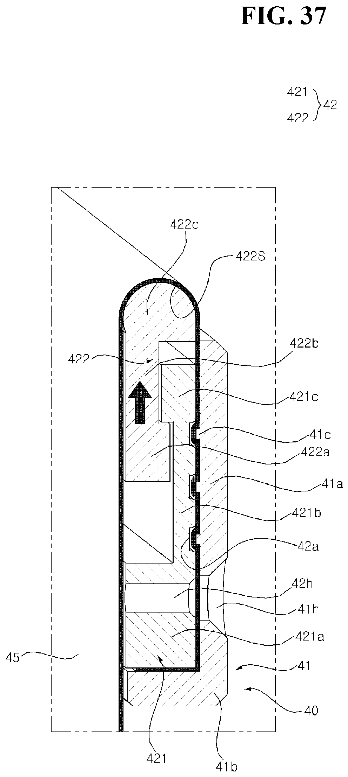

Referring to FIGS. 36 and 37, the light-shielding film 45 may be coupled to the bar 40. The light-shielding film 45 may be wound around the second piece 42. The second piece 42 around which the light-shielding film 45 is wound may be coupled to the first piece 41, and the light-shielding film 45 may be engaged or secured between the first piece 41 and the second piece 42.

An end of the light-shielding film 45 may be positioned on a lower surface of the lower piece 421 of the second piece 42. As the second part 41b of the first piece 41 and the lower surface of the lower piece 421 are engaged with each other, the light-shielding film 45 may be fixed. As the lower piece 421 and the first part 41b of the first piece 41 are engaged with each other, the light-shielding film 45 may be inserted into the rib groove 42a by the fixing rib 41c. The fixing rib 41c and the rib groove 42a may allow the light-shielding film 45 to be more firmly fixed, and may prevent wrinkling of the light-shielding film 45 in a longitudinal direction of the bar 40.

The light-shielding film 45 may be wound around the upper piece 422 of the second piece 42. The light-shielding film 45 may be positioned opposite the first piece 41 with respect to the upper piece 422 while surrounding the rounded surface 422s of the upper piece 422. The light-shielding film 45 may contact the upper piece 422 and the lower piece 421. The light-shielding film 45 may contact the first piece 41.

As the light-shielding film 45 is wound around and unwound from the rollers 72 and 73 (see FIG. 17), tension applied to the light-shielding film 45 may vary. As the tension applied to the light-shielding film 45 changes, the light-shielding film 45 may become loose while being unwound from or wound around the rollers 72 and 73. As the upper piece 422 of the bar 40 moves with respect to the lower piece 421, the upper piece 422 may respond to a change in the tension applied to the light-shielding film 45. Accordingly, loosening of the light-shielding film 45 while being wound around or unwound from the rollers 72 and 73 may be prevented, and the light-shielding film 45 may be maintained in a taut state.

When the tension applied to the light-shielding film 45 increases, the upper piece 422 may move in a direction toward the lower piece 421 (see FIG. 36). When the tension applied to the light-shielding film 45 decreases, the upper piece 422 may move in a direction away from the lower piece 421 (see FIG. 37). As the upper piece 422 moves while receiving an elastic force with respect to the lower piece 421, the upper piece 422 may more effectively respond to a change in the tension applied to the light-shielding film 45.

Referring to FIGS. 1 to 37, a display device may include: a display panel configured to display an image and having light transmittance; a transparent panel facing the display panel; a side frame elongated along a lateral side of the display panel and coupled to the transparent panel; a belt embedded in the side frame and configured to move along a longitudinal direction of the side frame; a bar extending in a direction intersecting the side frame and having one end fixed to the belt; a roller adjacent to a lower side connected to the lateral side of the display panel, elongated along the lower side of the display panel, and configured to be rotatable; a light-shielding film having one end fixed to the bar and another end coupled to the roller, such that the light-shielding film is wound around or unwound from the roller when the bar moves; an upper pulley disposed at an upper side of the side frame and around which the belt is wound; and a driving pulley disposed adjacent to a lower side of the side frame, facing the light-shielding film, configured to rotate about an axis extending in a thickness direction of the light-shielding film, and around which the belt is wound. The bar may include: a first piece forming a portion of the bar; and a second piece coupled to the first piece and around which the light-shielding film is wound. The second piece may include: a lower piece fixed to the first piece; and an upper piece configured to move on the lower piece in a direction from the driving pulley toward the upper pulley.

The one end of the light-shielding film may be positioned between the first piece and the second piece. The light-shielding film may be secured by the first piece and the second piece between the first piece and the second piece. The light-shielding film may be wound around the second piece and may extend from the upper pulley toward the driving pulley to be wound around the roller.

The bar may further include an up-down pole extending in a direction in which the upper piece moves with respect to the lower piece and fixed to the lower piece. The up-down pole may be inserted into the upper piece to allow the upper piece to reciprocate in a longitudinal direction of the up-down pole.

The bar may further include an elastic member into which the up-down pole is inserted, the elastic member being disposed between the lower piece and the upper piece.

The second piece may include a rounded surface around which the light-shielding film is wound. The rounded surface may face the upper pulley.

The first piece may include: a first part facing the second piece and including a fixing rib protruding toward the second piece; and a second part bent from the first part and facing the second piece with the one end of the light-shielding film interposed therebetween. The second piece may include a rib groove into which the fixing rib is inserted. The light-shielding film may be inserted into the rib groove by the fixing rib.

The second piece may include: a lower piece in which the rib groove is formed; an up-down pole fixed to the lower piece; and an upper piece configured to move with respect to the lower piece on the up-down pole. The light-shielding film may be wound around the upper piece and may cover outer surfaces of the upper piece and the lower piece.

The second piece may further include an elastic member into which the up-down pole is inserted, the elastic member being disposed between the upper piece and the lower piece to have one end supported by the lower piece and another end supported by the upper piece.

The display device may further include: a gear box connected to a shaft of the driving pulley and positioned opposite the light-shielding film with respect to the driving pulley; and a motor configured to provide a rotational force to the gear box and facing the light-shielding film.

The display device may further include a housing frame positioned opposite the display panel with respect to the light-shielding film and coupled to the side frame. The driving pulley may be rotatably coupled to the housing frame.

The display device may further include a pulley mount coupled to the housing frame and configured to accommodate the driving pulley. The pulley mount may include: a flange portion fixed to the housing frame; a pulley housing connected to the flange portion to accommodate the driving pulley, and in which the driving pulley rotates; a bearing mount connected to the pulley housing and covering the driving pulley; and a shaft mount through which a shaft of the driving pulley passes.

The display device may further include a bearing fixed to the bearing mount, the bearing being coupled to the driving pulley so as to rotate together with the driving pulley.

The driving pulley may be spaced apart from the light-shielding film by a predetermined distance.

The display device may further include: a housing frame positioned opposite the display panel with respect to the light-shielding film, the housing frame being coupled to the side frame; a gear box fixed to the housing frame, connected to a shaft of the driving pulley, and positioned opposite the light-shielding film with respect to the driving pulley; and a motor fixed to the housing frame, configured to provide a rotational force to the gear box, and positioned opposite the light-shielding film with respect to the housing frame.

The display device may further include: a joint connecting the shaft of the driving pulley and the gear box; and a rotation counter fixed to a shaft of the motor so as to rotate together with the shaft of the motor.

Certain embodiments or other embodiments of the disclosure described above are not mutually exclusive or distinct from each other. Any or all elements of the embodiments of the disclosure described above may be combined or combined with each other in configuration or function.

For example, a configuration "A" described in one embodiment of the disclosure and the drawings, and a configuration "B" described in another embodiment of the disclosure and the drawings may be combined with each other. Namely, although the combination between the configurations is not directly described, the combination is possible except in the case where it is described that the combination is impossible.

The above detailed description is to be construed in all aspects as illustrative and not restrictive. The scope of the present disclosure should be determined by reasonable interpretation of the appended claims, and all changes coming within the equivalents of the present disclosure are intended to be embraced in the scope of the present disclosure.

## Claims

1. A display device comprising:
a display panel configured to display an image and having light transmittance;
a transparent panel facing the display panel;
a side frame elongated along a lateral side of the display panel and coupled to the transparent panel;
a belt embedded in the side frame and configured to move along a longitudinal direction of the side frame;
a bar extending in a direction intersecting the side frame, the bar having one end fixed to the belt;
a roller adjacent to a lower side connected to the lateral side of the display panel, elongated along the lower side of the display panel, and configured to be rotatable;
a light-shielding film having one end fixed to the bar and another end coupled to the roller, such that the light-shielding film is wound around or unwound from the roller when the bar moves;
an upper pulley disposed at an upper side of the side frame and around which the belt is wound; and
a driving pulley disposed adjacent to a lower side of the side frame, facing the light-shielding film, configured to rotate about an axis extending in a thickness direction of the light-shielding film, and around which the belt is wound,
wherein the bar comprises:
a first piece forming a portion of the bar; and
a second piece coupled to the first piece and around which the light-shielding film is wound, and
wherein the second piece comprises:
a lower piece fixed to the first piece; and
an upper piece configured to move on the lower piece in a direction from the driving pulley toward the upper pulley.

2. The display device of claim 1, wherein the one end of the light-shielding film is positioned between the first piece and the second piece,
wherein the light-shielding film is secured by the first piece and the second piece between the first piece and the second piece, and
wherein the light-shielding film is wound around the second piece and extends from the upper pulley toward the driving pulley to be wound around the roller.

3. The display device of claim 2, wherein the bar further comprises an up-down pole extending in a direction in which the upper piece moves with respect to the lower piece, the up-down pole being fixed to the lower piece, and
wherein the up-down pole is inserted into the upper piece to allow the upper piece to reciprocate in a longitudinal direction of the up-down pole.

4. The display device of claim 3, wherein the bar further comprises an elastic member into which the up-down pole is inserted, the elastic member being disposed between the lower piece and the upper piece.

5. The display device of claim 1, wherein the second piece includes a rounded surface around which the light-shielding film is wound, and
wherein the rounded surface faces the upper pulley.

6. The display device of claim 1, wherein the first piece comprises:
a first part facing the second piece and including a fixing rib protruding toward the second piece; and
a second part bent from the first part and facing the second piece with the one end of the light-shielding film interposed therebetween,
wherein the second piece includes a rib groove into which the fixing rib is inserted, and
wherein the light-shielding film is inserted into the rib groove by the fixing rib.

7. The display device of claim 6, wherein the second piece comprises:
a lower piece in which the rib groove is formed;
an up-down pole fixed to the lower piece; and
an upper piece configured to move with respect to the lower piece on the up-down pole, and
wherein the light-shielding film is wound around the upper piece and covers outer surfaces of the upper piece and the lower piece.

8. The display device of claim 7, wherein the second piece further comprises an elastic member into which the up-down pole is inserted, the elastic member being disposed between the upper piece and the lower piece to have one end supported by the lower piece and another end supported by the upper piece.

9. The display device of claim 1, further comprising:
a gear box connected to a shaft of the driving pulley and positioned opposite the light-shielding film with respect to the driving pulley; and
a motor configured to provide a rotational force to the gear box and facing the light-shielding film.

10. The display device of claim 1, further comprising a housing frame positioned opposite the display panel with respect to the light-shielding film, the housing frame being coupled to the side frame,
wherein the driving pulley is rotatably coupled to the housing frame.

11. The display device of claim 10, further comprising a pulley mount coupled to the housing frame and configured to accommodate the driving pulley,
wherein the pulley mount comprises:
a flange portion fixed to the housing frame;
a pulley housing connected to the flange portion to accommodate the driving pulley, and in which the driving pulley rotates;
a bearing mount connected to the pulley housing and covering the driving pulley; and
a shaft mount through which a shaft of the driving pulley passes.

12. The display device of claim 11, further comprising a bearing fixed to the bearing mount, the bearing being coupled to the driving pulley so as to rotate together with the driving pulley.

13. The display device of claim 10, wherein the driving pulley is spaced apart from the light-shielding film by a predetermined distance.

14. The display device of claim 1, further comprising:
a housing frame positioned opposite the display panel with respect to the light-shielding film, the housing frame being coupled to the side frame;
a gear box fixed to the housing frame, connected to a shaft of the driving pulley, and positioned opposite the light-shielding film with respect to the driving pulley; and
a motor fixed to the housing frame, configured to provide a rotational force to the gear box, and positioned opposite the light-shielding film with respect to the housing frame.

15. The display device of claim 14, further comprising:
a joint connecting the shaft of the driving pulley and the gear box; and
a rotation counter fixed to a shaft of the motor so as to rotate together with the shaft of the motor.
